# EUROPEAN PATENT APPLICATION

(11) **EP 4 664 519 A1**
(43) Date of publication of application: **17.12.2025**
(21) Application number: 24753224.5
(22) Date of filing: 01.02.2024
(51) Int. Cl.: H01L 23/373, C09K 5/14, C22C 13/00, C22C 28/00, C22C 30/04

(54) **THERMALLY CONDUCTIVE COMPOSITION**

(30) Priority: 09.02.2023 JP 2023018033
(71) Applicant: Shin-Etsu Chemical Co., Ltd., Tokyo 100-0005 (JP)
(72) Inventor: YAMAGUCHI, Takahiro, Annaka-shi, Gunma 379-0224 (JP); YAMADA, Kunihiro, Annaka-shi, Gunma 379-0224 (JP); TSUJI, Kenichi, Annaka-shi, Gunma 379-0224 (JP); KITAZAWA, Keita, Annaka-shi, Gunma 379-0224 (JP); ARAI, Ayato, Annaka-shi, Gunma 379-0224 (JP)
(74) Representative: Angerhausen, Christoph
(86) International application number: PCT/JP2024/003230
(87) International publication number: WO 2024/166781

(57) **Abstract**

Provided is a thermally conductive composition that is excellent in thermal conductivity and also excellent in workability as well. The thermally conductive composition comprises: (A) 100 parts by mass of gallium and/or an alloy thereof having a melting point of -20 to 100°C; and (B) 2 to 150 parts by mass of a metal oxide and/or metal nitride having an average particle diameter of 0.01 µm to 200 µm with respect to 100 parts by mass of the component (A), wherein the total content of the components (A) and (B) in the composition is 95 to 100% by mass. In the thermally conductive composition, the gallium alloy serving as the component (A) includes one or more selected from Ga-In alloys, Ga-Sn-Zn alloys, Ga-In-Sn alloys, and Ga-In-Bi-Sn alloys.

## Description

### Technical Field

The present invention relates to a thermally conductive composition that is excellent in thermal conductivity and is also excellent in workability as well.

### Background Art

Heat dissipators such as heat sinks have been widely used for many heat-generating electronic components, such as CPUs, mounted on printed wiring boards to prevent damage, performance decline, and the like due to rise in temperature during use. For efficient conduction of heat generated from a heat-generating electronic component to a heat dissipator, a thermally conductive material is generally used between the heat-generating electronic component and the heat dissipator. However, as the amount of heat generation tends to increase with the improvement in performances of electronic components and the like, there has been a demand for development of materials and members having better thermal conductivities than those of conventional ones.

Since electrical and electronic components generally generate heat during use, heat removal measures are necessary for the electrical components to operate properly. For this reason, various thermally conductive materials for heat removal have been proposed. The thermally conductive materials are generally classified into two types by shape: 1) a sheet-like shape, which is easy to handle, and 2) a paste-like shape.

The heat dissipation sheet can easily be mounted on a heat-generating electronic component or a heat dissipator, but a space may be created at an interface with the heat-generating electronic component or the heat dissipator. This increases the interfacial thermal resistance, resulting in insufficient thermal conductivity. On the other hand, the paste-like heat dissipation material has properties similar to those of liquid, and hence has a small influence on the unevenness of the surface of the heat-generating electronic component or the heat dissipator, so that the paste-like heat dissipation material comes into close contact with the two, thereby reducing the interfacial thermal resistance. However, no paste-like heat dissipation materials have yet provided a sufficient heat dissipation performance.

In this respect, for example, Patent Documents 1 to 5 propose thermally conductive materials in which a low-melting point metal, a metal filler, or the like is blended as a component for imparting thermal conductivity to a silicone resin. However, since the higher integration and higher speed of recent heat-generating electronic components have further increased the amount of heat generation, no thermally conductive materials have not yet provided sufficient thermal conduction effects.

In addition, blending base oils such as polyorganosiloxanes (including silicone oils, silicone rubbers, and silicone resins) or hydrocarbon-based synthetic oils, which had been used as base materials for conventional thermally conductive compositions, may lower the thermal conductivity of thermally conductive compositions in some cases. Hence, it is desirable that none of these base oils be contained.

Patent Documents 6 to 8 disclose heat dissipation greases comprising a low-melting point metal (including alloys of gallium, indium, and tin) as a base material, and a thermally conductive filler. Regarding the types of filler, Patent Document 7 discloses tungsten, molybdenum, and silicon metal, Patent Document 6 discloses boron nitride, alumina, and aluminum nitride, and Patent Document 8 discloses ceramic powder. However, Patent Documents 6 and 8 fail to evaluate the appearance, workability, thermal conductivity, and the like of the compositions.

Regarding Patent Document 9, the filler is a metal fine powder, and a silver powder or a copper powder is used in Working Examples. However, the thermal conductivities are about 10 to 30 W/(m·K), which are not sufficient.

### PRIOR ART DOCUMENTS

### Patent documents

Patent Document 1: JP-A-2003-176414
Patent Document 2: JP-A-2005-112961
Patent Document 3: JP-A-2003-218296
Patent Document 4: JP-A-2004-039829
Patent Document 5: JP-A-2007-106809
Patent Document 6: JP-A-H03-071992
Patent Document 7: JP-A-2001-329068
Patent Document 8: JP-A-2004-071816
Patent Document 9: JP-A-2012-111823

### Summary of Invention

### Technical Problem

Accordingly, it is an object of the present invention to provide a thermally conductive composition that is substantially free of base oils such as polyorganosiloxanes (including silicone oils, silicone rubbers, and silicone resins) or hydrocarbon-based synthetic oils, which have been used as base materials in conventional thermally conductive compositions, and that is excellent in thermal conductivity and also excellent in workability.

### Solution to Problem

To achieve the above-described object, the present inventors have conducted intensive studies, and consequently have developed a paste-like thermally conductive composition having an improved workability and a high thermal conductivity of 30 W/m·K or higher by blending gallium and/or a gallium alloy with a metal oxide and/or metal nitride having a specific particle diameter, thereby lowering the flowability of the low-melting point metal.

The present inventors have found that the thermally conductive composition can be used as a thermally conductive layer having a low thermal resistance by placing the thermally conductive composition between a heat-generating electronic component and a heat dissipation member as in the case of conventional thermally conductive greases, and causing the thermally conductive composition to conform to the unevenness on the surface of the component or the member to prevent formation of a space, and that heat dissipation performance excellent in heat dissipation performance can be obtained by allowing heat generated during operation of the heat-generating electronic component to rapidly be conducted to the heat dissipation member through the thermally conductive layer comprising gallium and/or an alloy thereof held in the structure as described above. This finding has led to the completion of the present invention.

Specifically, the present invention provides the following thermally conductive composition.

<1> A thermally conductive composition, comprising:
   (A) 100 parts by mass of gallium and/or an alloy thereof having a melting point of -20 to 100°C; and
   (B) 2 to 150 parts by mass of a metal oxide and/or metal nitride, having an average particle diameter of 0.01 µm to 200 µm, with respect to 100 parts by mass of the component (A),
   wherein the total content of the components (A) and (B) in the composition is 95 to 100% by mass.
<2> The thermally conductive composition according to <1>, wherein the total content of the components (A) and (B) in the composition is 98 to 100% by mass.
<3> The thermally conductive composition according to <1> or <2>, wherein the gallium alloy serving as the component (A) comprises one or more selected from Ga-In alloys, Ga-Sn-Zn alloys, Ga-In-Sn alloys, and Ga-In-Bi-Sn alloys.
<4> The thermally conductive composition according to any one of <1> to <3>, wherein the component (B) comprises one or more selected from zinc oxide powder, alumina powder, boron nitride powder, silicon nitride powder, aluminum nitride powder, aluminum hydroxide powder, and magnesium oxide powder.
<5>The thermally conductive composition according to one of <1> to <4>, further comprising, as a component (C), 0.01 to 10 parts by mass, with respect to 100 parts by mass of the component (A), of hydrophobic spherical silica fine particles as defined in the following,
   wherein the hydrophobic spherical silica fine particles are those in which R¹SiO_{3/2} units and R²₃SiO_{1/2} units are introduced onto surfaces of hydrophilic spherical silica fine particles that have been obtained by hydrolyzing and condensing a tetrafunctional silane compound, a partially hydrolyzed and condensed product thereof, or a mixture thereof and that are substantially composed of SiO₂ units,
      wherein R¹ is a substituted or unsubstituted monovalent hydrocarbon group having 1 to 20 carbon atoms, and
      wherein R²s are substituted or unsubstituted monovalent hydrocarbon groups having 1 to 8 carbon atoms and are same or different from each other, and
   wherein the hydrophobic spherical silica fine particles have particle diameters in a range of 0.005 to 1 µm, a particle size distribution D₉₀/D₁₀ value of 3 or lower, and an average circularity of 0.8 to 1.
<6> The thermally conductive composition according to one of <1> to <5>, further comprising, as a component (D), 0.001 to 10 parts by mass of an organosilane represented by the following general formula (1) with respect to 100 parts by mass of the component (A):

   R¹ₐR²_{b}Si(OR³)₄₋ₐ₋₆ (1),

   wherein R¹s are each independently a substituted or unsubstituted alkyl group having 1 to 20 carbon atoms, R²s are each independently a substituted or unsubstituted monovalent hydrocarbon group other than alkyl groups, R³s are the same or different monovalent hydrocarbon groups having 1 to 6 carbon atoms, a is a number of 1 to 3, b is a number of 0 to 2, and the sum of a + b is a number of 1 to 3.

### Advantageous Effects of Invention

The thermally conductive composition of the present invention has a strong surface activity, is sufficiently spread by wetting when spread by pushing, is excellent in workability, and further has an increased thermal conductivity. Accordingly, the composition of the present invention is useful for members on which gallium or a gallium alloy alone forms droplets due to the surface tension, and is difficult to handle, conventionally. In addition, the combined use of components (B) having different average particle diameters makes it possible to obtain a thermally conductive composition having a high thermal conductivity of 70 W/m·K or higher and also being excellent in workability.

### Brief Description of Drawings

[Fig. 1] Fig. 1 is a photograph showing that when spread by pushing with a spatula, a discharged composition takes a state of being sufficiently spread by wetting.
[Fig. 2] Fig. 2 is a photograph showing that when spread by pushing with a spatula, a discharged composition takes a state of being not sufficiently spread by wetting.

### Description of Embodiments

Hereinafter, the present invention will be described in detail.

### Component (A)

The component (A) of the composition of the present invention is gallium and a gallium alloy, and it is necessary that the melting point thereof be in the range of -20 to 100°C. A gallium alloy having a melting point lower than -20°C is not economically preferable, because of the difficulty in production. When the melting point exceeds 100°C, such a gallium alloy does not melt rapidly in a preparation step of the composition, resulting in poor workability, or the gallium alloy may precipitate during production to make the composition heterogeneous. Thus, the requirement that the gallium or gallium alloy should have a melting point in the range of -20 to 100°C is necessary in terms of cost efficiency and handling, and also this range is appropriate. In particular, gallium or a gallium alloy having a melting point in the range of -20 to 50°C is preferable.

The melting point of gallium metal is 29.8°C. Meanwhile, typical examples of gallium alloys having a melting point in the above-described range include gallium-indium alloys; for example, Ga-In (mass ratio = 75.4:24.6, melting point = 15.7°C), gallium-tin alloys, gallium-tin-zinc alloys; for example, Ga-Sn-Zn (mass ratio = 82:12:6, melting point = 17°C), gallium-indium-tin alloys; for example, Ga-In-Sn (mass ratio = 68.5:21.5:10, melting point = 19°C, or mass ratio = 62.0:25.0:13.0, melting point = 5.0°C, or mass ratio = 21.5:16.0:62.5, melting point = 10.7°C), gallium-indium-bismuth-tin alloys; for example, Ga-In-Bi-Sn (mass ratio = 9.4:47.3:24.7:18.6, melting point = 48.0°C), and the like.

It is possible to use one component (A) alone or two or more components (A) in combination.

Gallium and/or an alloy thereof present in the composition of the present invention is a low-melting point metal, and is used as a base material (base). In other words, the low-melting point metal is a main component of the thermally conductive composition of the present invention.

Note that blending, in the composition of the present invention, base oils such as polyorganosiloxanes (including silicone oils, silicone rubbers, and silicone resins) or hydrocarbon-based synthetic oils, which had been used as base materials in conventional thermally conductive compositions, may lower the thermal conductivity of the composition of the present invention in some cases, and hence it is preferable that these base oils be not contained. The upper limit value of the content ratio of these base oils in the entire composition of the present invention is preferably 1.0% by mass or less, and more preferably 0.5% by mass or less, and the content ratio is particularly preferably such that substantially no base oils be contained.

### Component (B)

The composition of the present invention comprises a metal oxide and/or a metal nitride as a thermally conductive filler. The type of the thermally conductive filler is not particularly limited, and it is possible to use powders that have been used for heat dissipation (thermally conductive) greases, conventionally. In particular, powders having high thermal conductivity are preferable, and one or two or more selected from zinc oxide powder, alumina powder, boron nitride powder, silicon nitride powder, aluminum nitride powder, aluminum hydroxide powder, and magnesium oxide powder are preferable. It is also possible to use a thermally conductive filler whose surface has been subjected to a hydrophobization treatment with an organosilane, an organosilazane, an organopolysiloxane, an organic fluorine compound, or the like, if necessary.

The thermally conductive filler has an average particle diameter of 0.01 to 200 µm, and preferably has an average particle diameter of 0.1 to 150 µm, and more preferably 0.5 to 120 µm. Suppose a case where the average particle diameter of the thermally conductive filler is smaller than 0.01 µm, or a case where the average particle diameter exceeds 200 µm. Either case may be undesirable, because the ratio of the thermally conductive filler loaded in the obtained composition cannot be increased. One of these thermally conductive fillers may be used alone, or two or more thermally conductive fillers having different average particle diameters may be used as a mixture. The above-described average particle diameter is a volume-based cumulative average diameter. The average particle diameter can be measured by using a laser diffraction and scattering particle diameter distribution-measuring instruments, and can be measured by using, for example, a particle size analyzer MICROTRAC MT3300EX manufactured by NIKKISO CO., LTD.

The amount of the thermally conductive filler blended is in the range of 2 to 150 parts by mass with respect to 100 parts by mass of the component (A), and is preferably in the range of 2 to 100 parts by mass, more preferably in the range of 2 to 80 parts by mass, and further preferably in the range of 5 to 60 parts by mass. If the amount of the thermally conductive filler blended is less than 2 parts by mass, sufficient thermal conductivity cannot be imparted to the composition in some cases. Meanwhile, if the amount of the thermally conductive filler blended exceeds 150 parts by mass, the thermally conductive filler cannot be dispersed in the low-melting point metal, and becomes powdery, in some cases.

It is preferable to use two or more metal oxides and/or metal nitrides having different average particle diameters as the component (B), because the thermal conductivity of the composition is improved.

For example, it is preferable that a metal oxide or metal nitride having an average particle diameter of 70 to 200 µm be contained as a component (B) at a ratio of 55% by mass or more but less than 100% by mass with respect to the entire component (B) in terms of mass, and the ratio is more preferably 57 to 90% by mass, and further preferably 59 to 85% by mass.

The total content of the components (A) and (B) in the entire composition of the present invention is 95 to 100% by mass, preferably 98 to 100% by mass, and more preferably 99 to 100% by mass.

The following components are optional and may be added if necessary.

### Component (C)

A component (C) of the composition of the present invention is hydrophobic spherical silica fine particles. The hydrophobic spherical silica fine particles are those in which R¹SiO_{3/2} units, wherein R¹ is a substituted or unsubstituted monovalent hydrocarbon group having 1 to 20 carbon atoms, and R²₃SiO_{1/2} units, wherein R²s are the same or different from each other and are substituted or unsubstituted monovalent hydrocarbon groups having 1 to 6 carbon atoms, are introduced onto surfaces of hydrophilic spherical silica fine particles that have been obtained by hydrolyzing and condensing a tetrafunctional silane compound, a partially hydrolyzed and condensed product thereof, or a mixture thereof and that are substantially composed of SiO₂ units, have particle diameters in the range of 0.005 to 1 µm, have a particle size distribution D₉₀/D₁₀ value of 3 or lower, and have an average circularity of 0.8 to 1.

The hydrophobic spherical silica fine particles have particle diameters of preferably 0.005 to 1 µm, more preferably 0.01 to 0.3 µm, and particularly preferably 0.03 to 0.25 µm. If the particle diameters are smaller than 0.005 µm, intense aggregation occurs. Meanwhile, if the particle diameters are larger than 1 µm, an effect of lowering the viscosity of a grease composition is reduced in some cases.

The D₉₀/D₁₀ value, which is an index of the particle size distribution of the hydrophobic spherical silica fine particles, is preferably 3 or lower, and more preferably 2.9 or lower. Here, D₁₀ and D₉₀ are each a value obtained by measuring the distribution of particle diameters. In a case where the distribution of particle diameters of a powder is measured, the particle diameter at which cumulative 10% from the smaller side is reached is denoted by D₁₀, and the particle diameter at which cumulative 90% from the smaller side is reached is denoted by D₉₀. Since this D₉₀/D₁₀ is 3 or lower, the hydrophobic spherical silica fine particles of the present invention are characterized by having a sharp particle size distribution. Uniform particles having such a sharp particle size distribution are preferable in terms of effectiveness in lowering the viscosity of the grease composition.

Note that, regarding the particle size distribution of fine particles in the present invention, a volume-based median diameter obtained by measurement with a NANOTRAC particle size distribution-measuring instrument (manufactured by NIKKISO CO., LTD. under the trade name: UPA-EX150) based on the dynamic light scattering/laser doppler method is employed as the particle diameter. Note that the median diameter refers to a particle diameter which corresponds to cumulative 50% in a case where the particle size distribution is expressed as a cumulative distribution.

In addition, the average circularity of the above-described hydrophobic spherical silica fine particles is preferably 0.8 to 1. The term "spherical" herein encompasses not only perfect spheres, but also somewhat distorted spheres. The "spherical" shape is evaluated based on the circularity of a two-dimensional projection of a particle, and refers to a shape whose circularity is in the range of 0.8 to 1. Here, the circularity is (the perimeter of a circle having an area equal to the area of a particle)/(the perimeter of the particle). In addition, the average circularity is an average value obtained by measuring the circularities of 10 silica fine particles. The circularity can be determined by image analysis of an image of a particle obtained with an electron microscope or the like.

As used herein, the sentence: hydrophilic spherical silica fine particles are "substantially composed of SiO₂ units" means that the fine particles are basically composed of SiO₂ units, but do not consist of the units alone, and have many silanol groups on at least the surfaces, as is known commonly. In some cases, this sentence also means that some of the hydrolyzable groups (hydrocarbyloxy groups) derived from the tetrafunctional silane compound and/or the partially hydrolyzed and condensed product thereof serving as a raw material are not converted into silanol groups, and a certain amount of the hydrolyzable groups may remain intact on the surfaces of or inside the fine particles.

Regarding the composition of the present invention, when a powder (hydrophobic spherical silica fine particles) is obtained by using, as a silica raw material (silica before a hydrophobization treatment), a silica that has been obtained by hydrolysis (sol-gel process) of a tetraalkoxysilane and that has a small grain diameter, and conducting a specific surface treatment on the silica raw material, the primary particle diameters of the silica raw material are retained as the particle diameters after the hydrophobization treatment, and hence the aggregation of the hydrophobic spherical silica fine particles can be prevented.

To obtain a silica raw material having a certain particle diameter, the reaction conditions can be changed; for example, a tetraalkoxysilane having an alkoxy group with a smaller number of carbon atoms can be used for a silica raw material, an alcohol having a smaller number of carbon atoms can be used as the solvent, a higher temperature can be employed for the hydrolysis, the tetraalkoxysilane can be used at a lower concentration during the hydrolysis, or a hydrolysis catalyst can be used at a lower concentration.

By subjecting the silica raw material to a specific surface treatment, desired hydrophobic spherical silica fine particles can be obtained.

Hereinafter, a method for producing hydrophobic spherical silica fine particles will be described in detail, but the method for producing the hydrophobic spherical silica fine particles is a non-limiting example.

### <Method for Producing Hydrophobic Spherical Silica Fine Particles serving as Component (C)>

The hydrophobic spherical silica fine particles serving as the component (C) is obtained by
Step (C1): a synthesis step of hydrophilic spherical silica fine particles,
Step (C2): a surface treatment step with a trifunctional silane compound, and
Step (C3): a surface treatment step with a monofunctional silane compound. Hereinafter, the steps are described one by one.

### ·Step (C1): Synthesis Step of Hydrophilic Spherical Silica Fine Particles

A tetrafunctional silane compound represented by general formula (I):

Si(OR³)₄ (I),

wherein R³s are the same or different monovalent hydrocarbon groups having 1 to 6 carbon atoms, a partially hydrolyzed product thereof, or a mixture thereof is subjected to hydrolysis and condensation in a mixture liquid of a hydrophilic organic solvent and water containing a basic substance, to obtain a mixture solvent dispersion of hydrophilic spherical silica fine particles.

In general formula (I), R³ is a monovalent hydrocarbon group having 1 to 6 carbon atoms, and is a monovalent hydrocarbon group preferably having 1 to 4 carbon atoms, and particularly preferably having 1 to 2 carbon atoms. Examples of the monovalent hydrocarbon group represented by R³ include alkyl groups such as a methyl group, an ethyl group, a propyl group, and a butyl group; and aryl groups such as a phenyl group, and preferred is a methyl group, an ethyl group, a propyl group, or a butyl group, and particularly preferred is a methyl group or an ethyl group.

Examples of the tetrafunctional silane compound represented by general formula (I) include tetraalkoxysilanes such as tetramethoxysilane, tetraethoxysilane, tetrapropoxysilane, and tetrabutoxysilane; and tetraphenoxy silane, and preferred are tetramethoxysilane, tetraethoxysilane, tetrapropoxysilane, and tetrabutoxysilane, and particularly preferred are tetramethoxysilane and tetraethoxysilane. Meanwhile, examples of the partially hydrolyzed and condensed product of the tetrafunctional silane compound represented by general formula (I) include alkyl silicates such as methyl silicate and ethyl silicate.

The above-described hydrophilic organic solvent is not particularly limited, as long as the solvent dissolves the tetrafunctional silane compound represented by general formula (I), a partially hydrolyzed and condensed product thereof, and water. Examples thereof include alcohols such as methanol, ethanol, propanol, isopropanol, and butanol; Cellosolves such as Methyl Cellosolve, Ethyl Cellosolve, Butyl Cellosolve, and Cellosolve Acetate; ketones such as acetone and methyl ethyl ketone; ethers such as dioxane and tetrahydrofuran; and the like, and preferred are alcohols and Cellosolves, and particularly preferred are alcohols.

The alcohols include alcohols represented by the following general formula (VII):

R¹¹OH (VII),

wherein R¹¹ is a monovalent hydrocarbon group having 1 to 6 carbon atoms.

In general formula (VII), R¹¹ is a monovalent hydrocarbon group having preferably 1 to 4, particularly preferably 1 to 2 carbon atoms. Examples of the monovalent hydrocarbon group represented by R¹¹ include alkyl groups such as a methyl group, an ethyl group, a propyl group, an isopropyl group, and a butyl group, and preferred are a methyl group, an ethyl group, a propyl group, and an isopropyl group, and more preferred are a methyl group and an ethyl group. Examples of the alcohol represented by general formula (VII) include methanol, ethanol, propanol, isopropanol, butanol, and the like, and preferred are methanol and ethanol. As the number of carbon atoms of the alcohol increases, the particle diameters of the produced spherical silica fine particles increase in some cases. Accordingly, methanol is preferable to obtain an intended silica (silica raw material) having small grain diameters.

In addition, the basic substance may be ammonia, dimethylamine, diethylamine, or the like, preferably ammonia or diethylamine, and particularly preferably ammonia. A required amount of such a basic substance may be dissolved in water, and then the obtained aqueous solution (basic) may be mixed with the above-described hydrophilic organic solvent.

The amount of basic substance used is preferably 0.01 to 2 mol, more preferably 0.02 to 0.5 mol, and particularly preferably 0.04 to 0.12 mol per mole of all the hydrocarbyloxy groups of the tetrafunctional silane compound represented by general formula (I) and/or the partially hydrolyzed and condensed product thereof. Here, the smaller the amount of basic substance is, the more likely a desired silica (silica raw material) having small grain diameters can be obtained.

The amount of water used for the above-described hydrolysis and condensation is preferably 0.5 to 5 mol, more preferably 0.6 to 2 mol, and particularly preferably 0.7 to 1 mol per mole of all the hydrocarbyloxy groups of the tetrafunctional silane compound represented by general formula (I) and/or the partially hydrolyzed and condensed product thereof. The ratio (hydrophilic organic solvent:water) of the above-described hydrophilic organic solvent to water is preferably 0.5 to 10:1, more preferably 3 to 9:1, and particularly preferably 5 to 8:1 in terms of mass ratio. The more the amount of hydrophilic organic solvent is, the more likely a desired silica (silica raw material) having small grain diameters can be obtained.

The hydrolysis and condensation of the tetrafunctional silane compound represented by general formula (I) or the like is conducted by a well-known method, specifically, by adding the tetrafunctional silane compound represented by general formula (I) or the like into a mixture of a hydrophilic organic solvent and water that contains a basic substance.

The concentration of hydrophilic spherical silica fine particles in the mixture solvent dispersion of the silica raw material (hydrophilic spherical silica fine particles) obtained in this step (C1) is generally 3 to 15% by mass, and preferably 5 to 10% by mass.

### ·Step (C2): Surface Treatment Step with Trifunctional Silane Compound

To the mixture solvent dispersion of the silica raw material (hydrophilic spherical silica fine particles) obtained in step (C1), a trifunctional silane compound represented by general formula (II):

R¹Si(OR⁴)₃ (II),

wherein R¹ is a substituted or unsubstituted monovalent hydrocarbon group having 1 to 20 carbon atoms, and R⁴s are the same or different monovalent hydrocarbon groups having 1 to 6 carbon atoms, a partially hydrolyzed product thereof, or a mixture thereof is added to treat surfaces of the hydrophilic spherical silica fine particles therewith. Thus, R¹SiO_{3/2} units, wherein R¹ is a substituted or unsubstituted monovalent hydrocarbon group having 1 to 20 carbon atoms, are introduced to the surfaces of the hydrophilic spherical silica fine particles, to obtain a mixture solvent dispersion of first hydrophobic spherical silica fine particles.

This step (C2) is necessary for suppressing aggregation of the silica fine particles in the following concentration step. If the aggregation of the silica fine particles is not suppressed, the finally obtained hydrophobic spherical silica fine particles cannot retain the primary particle diameters, thus impairing the flowability-imparting ability.

In general formula (II), R¹ is a monovalent hydrocarbon group having preferably 1 to 3, particularly preferably 1 to 2 carbon atoms. Examples of the monovalent hydrocarbon group represented by R¹ include alkyl groups such as a methyl group, an ethyl group, a n-propyl group, an isopropyl group, a butyl group, and a hexyl group, and preferred is a methyl group, an ethyl group, a n-propyl group, or an isopropyl group, and particularly preferred is a methyl group or an ethyl group. Moreover, some or all of the hydrogen atoms of these monovalent hydrocarbon groups may be substituted with halogen atoms such as fluorine atoms, chlorine atoms, and bromine atoms, and preferably with fluorine atoms.

In general formula (II), R⁴s are independently monovalent hydrocarbon groups having preferably 1 to 3, particularly preferably 1 to 2 carbon atoms. Examples of the monovalent hydrocarbon groups represented by R⁴s include alkyl groups such as methyl groups, ethyl groups, propyl groups, and butyl groups, and preferred are methyl groups, ethyl groups, or propyl groups, and particularly preferred are methyl groups or ethyl groups.

Examples of the trifunctional silane compound represented by general formula (II) include unsubstituted or halogen-substituted trialkoxysilanes such as methyltrimethoxysilane, methyltriethoxysilane, ethyltrimethoxysilane, ethyltriethoxysilane, n-propyltrimethoxysilane, n-propyltriethoxysilane, isopropyltrimethoxysilane, isopropyltriethoxysilane, butyltrimethoxysilane, butyltriethoxysilane, hexyltrimethoxysilane, trifluoropropyltrimethoxysilane, and heptadecafluorodecyltrimethoxysilane; and the like, and preferred are methyltrimethoxysilane, methyltriethoxysilane, ethyltrimethoxysilane, and ethyltriethoxysilane, and more preferred are methyltrimethoxysilane and methyltriethoxysilane. Alternatively, the trifunctional silane compound represented by general formula (II) may be a partially hydrolyzed and condensed product thereof.

The amount of the trifunctional silane compound represented by general formula (II) added is 0.001 to 1 mol, preferably 0.01 to 0.1 mol, and particularly preferably 0.01 to 0.05 mol per mole of Si atoms of the hydrophilic spherical silica fine particles used. If the amount added is smaller than 0.001 mol, the dispersibility of the obtained hydrophobic spherical silica fine particles is impaired, so that there is a possibility that an effect of imparting flowability to boron nitride cannot be obtained. If the amount added is larger than 1 mol, aggregation of the silica fine particles may occur.

The concentration of the first hydrophobic spherical silica fine particles in the mixture solvent dispersion of first hydrophobic spherical silica fine particles obtained in this step (C2) is 3% by mass or higher and lower than 15% by mass, and preferably 5 to 10% by mass. If the concentration is lower than 3% by mass, the productivity may be lowered in some cases. If the concentration is 15% by mass or higher, aggregation of the silica fine particles may occur in some cases.

### · Concentration Step

Concentration is conducted by partially removing the hydrophilic organic solvent and water from the thus obtained mixture solvent dispersion of first hydrophobic spherical silica fine particles, to obtain a concentrated mixture solvent dispersion of the first hydrophobic spherical silica fine particles. Here, a hydrophobic organic solvent may be added in advance (before the concentration step) or during the concentration step. Here, the hydrophobic solvent used is preferably a hydrocarbon-based or ketone-based solvent. Specifically, the hydrophobic solvent may be toluene, xylene, methyl ethyl ketone, methyl isobutyl ketone, or the like, and is preferably methyl isobutyl ketone.

Examples of methods of partially removing the hydrophilic organic solvent and water include removal by distillation, removal by vacuum distillation, and the like. In the obtained concentrated mixture solvent dispersion, the concentration of the first hydrophobic spherical silica fine particles is preferably 15 to 40% by mass, more preferably 20 to 35% by mass, and particularly preferably 25 to 30% by mass. If the concentration is lower than 15% by mass, a surface treatment in step (C3) described later does not proceed smoothly in some cases. If the concentration is higher than 40% by mass, aggregation of the silica fine particles may occur in some cases.

The concentration step is also significant in terms of preventing, for example, such a problem that a silazane compound represented by general formula (III) and a monofunctional silane compound represented by general formula (IV) used as surface treatment agents in step (C3) described later react with alcohol or water to make the surface treatment insufficient, aggregation occurs during the subsequent drying, and the obtained silica powder cannot retain the primary particle diameters, thereby impairing the flowability-imparting ability.

### ·Step (C3): Surface Treatment Step with Monofunctional Silane Compound

To the concentrated mixture solvent dispersion obtained in the above-described concentration step, a silazane compound represented by general formula (III):

R²₃SiNHSiR²₃ (III),

wherein R²s are the same or different substituted or unsubstituted monovalent hydrocarbon groups having 1 to 8 carbon atoms, or a monofunctional silane compound represented by general formula (IV):

R²₃SiX (IV),

wherein R²s are the same or different substituted or unsubstituted monovalent hydrocarbon groups having 1 to 6 carbon atoms, and X is an OH group or a hydrolyzable group, or a mixture thereof is added, to treat surfaces of the first hydrophobic spherical silica fine particles, so that R²₃SiO_{1/2} units, wherein R² is as defined in general formula (III), are introduced onto the surfaces of the fine particles to obtain second hydrophobic spherical silica fine particles. As a consequence of the treatment in this step, R²₃SiO_{1/2} units are introduced onto the surfaces in the form of triorganosilylation of silanol groups remaining on the surfaces of the first hydrophobic spherical silica fine particles.

In the above-described general formulae (III) and (IV), R²s are monovalent hydrocarbon groups having preferably 1 to 4, particularly preferably 1 to 2 carbon atoms. Examples of the monovalent hydrocarbon groups represented by R²s include alkyl groups such as methyl groups, ethyl groups, propyl groups, isopropyl groups, and butyl groups, and preferred are methyl groups, ethyl groups, or propyl groups, and particularly preferred are methyl groups or ethyl groups. Moreover, some or all of the hydrogen atoms of these monovalent hydrocarbon groups may be substituted with halogen atoms such as fluorine atoms, chlorine atoms, and bromine atoms, and preferably with fluorine atoms.

Examples of the hydrolyzable group represented by X include a chlorine atom, an alkoxy group, an amino group, or an acyloxy group, and preferred is an alkoxy group or an amino group, and particularly preferred is an alkoxy group.

Examples of the silazane compound represented by general formula (III) include hexamethyldisilazane, hexaethyldisilazane, and the like, and preferred is hexamethyldisilazane.

Examples of the monofunctional silane compound represented by general formula (IV) include monosilanol compounds such as trimethylsilanol and triethylsilanol; monochlorosilanes such as trimethylchlorosilane and triethylchlorosilane; monoalkoxysilanes such as trimethylmethoxysilane and trimethylethoxysilane; monoaminosilanes such as trimethylsilyldimethylamine and trimethylsilyldiethylamine; and monoacyloxysilanes such as trimethylacetoxysilane, and preferred is trimethylsilanol, trimethylmethoxysilane, or trimethylsilyldiethylamine, and particularly preferred is trimethylsilanol or trimethylmethoxysilane.

The amount of the silazane compound and/or the monofunctional silane compound used is 0.1 to 0.5 mol, preferably 0.2 to 0.4 mol, and particularly preferably 0.25 to 0.35 mol per mole of Si atoms of the hydrophilic spherical silica fine particles used. An amount of use less than 0.1 mol results in a poor dispersibility of the obtained hydrophobic spherical silica fine particles. An amount of use exceeding 0.5 mol is economically disadvantageous.

The above-described hydrophobic spherical silica fine particles can be obtained as a powder by an ordinary method such as drying under normal pressure or drying under reduced pressure.

The amount of the component (C) blended is preferably 0.01 to 10 parts by mass, more preferably 0.05 to 5 parts by mass, and particularly preferably 0.1 to 5 parts by mass with respect to 100 parts by mass of the component (A). If the amount is smaller than 0.01 parts by mass, effects owing to the addition of the component (C) such as an effect of lowering the viscosity of the grease composition cannot be obtained. If the amount exceeds 10 parts by mass, there is a possibility that the viscosity of the grease composition may increase to impair the thermal conductivity, and moreover such an amount is uneconomical.

### Component (D)

The component (D) is added to the composition for the purpose of treating the surfaces of the powder (the component (B) and/or the component (C)), and can not only assist the high-loading of the powder, but also improve the moisture resistance of the component (A). Conventionally, there has been such a problem that when exposed to high humidity for a long period of time, gallium and gallium alloys themselves undergo oxidation, so that the thermal resistance of the silicone composition increases. However, with the component (D) contained, increase in thermal resistance is not observed even under high humidity, so that the performance can be maintained.

The component (D) is an organosilane represented by the following general formula (1):

R¹ₐR²_{b}Si(OR³)_{4-a-b} (1),

wherein R¹s are each independently a substituted or unsubstituted alkyl group having 1 to 20 carbon atoms, R²s are each independently a substituted or unsubstituted monovalent hydrocarbon group other than alkyl groups, R³s are the same or different monovalent hydrocarbon groups having 1 to 6 carbon atoms, a is a number of 1 to 3, b is a number of 0 to 2, and the sum of a + b is a number of 1 to 3.

Examples of R¹s in the above-described formula (1) include methyl groups, ethyl groups, propyl groups, butyl groups, pentyl groups, hexyl groups, octyl groups, nonyl groups, decyl groups, dodecyl groups, tetradecyl groups, hexadecyl groups, octadecyl groups, and icosyl group; cycloalkyl groups such as cyclopentyl groups and cyclohexyl groups; halogen-substituted alkyl groups such as 3-chloropropyl groups, 3,3,3-trifluoropropyl groups, 2-(nonafluorobutyl)ethyl groups, and 2-(heptadecafluorooctyl)ethyl groups; and the like. When the number of carbon atoms exceeds 20, the organosilane solidifies at normal temperature, making the organosilane inconvenient to handle, and degrading the low-temperature characteristics of the obtained composition. When a in formula (1) is 2 or 3, R¹s may be the same groups or different groups.

Meanwhile, examples of R²s in the above-described formula (1) include alkenyl groups such as vinyl groups and allyl groups; aryl groups such as phenyl groups and tolyl groups; aralkyl groups such as 2-phenylethyl groups and 2-methyl-2-phenylethyl groups; and halogenated hydrocarbon groups such as p-chlorophenyl groups. Of these examples, methyl groups and ethyl groups are particularly preferable.

Meanwhile, examples of R³s in the above-described formula (1) include alkyl groups such as methyl groups, ethyl groups, propyl groups, butyl groups, pentyl groups, and hexyl groups. Of these examples, methyl groups and ethyl groups are particularly preferable.

Specific preferred examples of the component (D) include the following:

CH₃Si(OCH₃)₃;

C₃H₇Si(OCH₃)₃;

C₆H₁₃Si(OCH₃)₃;

C₈H₁₇Si(OCH₃)₃;

C₁₀H₂₁Si(OCH₃)₃;

C₁₂H₂₅Si(OCH₃)₃;

C₁₆H₃₃Si(OCH₃)₃;

C₁₈H₃₇Si(OCH₃)₃;

C₂₀H₄₁Si(OCH₃)₃;

C₃H₇Si(OC₂H₅)₃;

C₆H₁₃Si(OC₂H₅)₃;

C₈H₁₇Si(OC₂H₅)₃;

C₁₀H₂₁Si(OC₂H₅)₃;

C₁₂H₂₅Si(OC₂H₅)₃;

C₁₈H₃₇Si(OC₂H₅)₃;

C₁₀H₂₁Si(CH₃)(OCH₃)₂;

C₁₀H₂₁Si(C₆H₅)(OCH₃)₂;

C₁₀H₂₁Si(CH₃)(OC₂H₅)₂;

C₁₀H₂₁Si(CH=CH₂)(OCH₃)₂;

C₁₀H₂₁Si(CH₂CH₂CF₃)(OCH₃)₂;

(ClCH₂CH₂CH₂)Si(OCH₃)₃; and

(ClCH₂CH₂CH₂)Si(OC₂H₅)₃.

Note that, as the component (D), one species can be used alone, or two or more species may be used in combination.

The amount of the component (D) blended is preferably 0.001 to 10 parts by mass, more preferably 0.001 to 5 parts by mass, and particularly preferably 0.001 to 2.5 parts by mass with respect to 100 parts by mass of the component (A). A blended amount exceeding 10 parts by mass is uneconomical, because a moisture resistance improvement effect does not increase. In addition, since the component (D) is somewhat volatile, the composition of the present invention may be gradually hardened in some cases, when left to stand in an open system.

### Additional Components

Moreover, if necessary, it is possible to blend a conventionally known antioxidant, dye, pigment, flame retardant, anti-settling agent, thixotropy-improving agent, and the like in the thermally conductive composition of the present invention, as long as an object of the present invention is not impaired.

### Production of Composition

A method for producing a thermally conductive composition of the present invention may be conducted according to a conventionally known method for producing a silicone grease composition, and is not particularly limited. However, while a silicone oil is used as a base in conventionally known methods, a low-melting point metal is used as a base in the present production method, and the components are added thereto. In a specific production method, for example, the composition can be produced by mixing, for 30 minutes to 4 hours, the above-described component (A) and component (B), and, if necessary, the component (C), the component (D) and/or the additional components in a kneader in which impellers move to perform planetary motion (rotation and revolution) in a stirring tank, for example, in a mixing apparatus such as TRI-MIX, TWIN-MIX, Planetary Mixer (each of which is a mixing apparatus manufactured by INOUE MFG., INC., registered trademarks), Ultra Mixer (which is a mixing apparatus manufactured by MIZUHO INDUSTRIAL CO., LTD., registered trademark), HIVIS DISPER MIX (a mixing apparatus manufactured by Tokushu Kika Kogyo Co., Ltd., registered trademark), or the like. When the component (A) is solid at room temperature, it is preferable to melt the component (A) by heating in advance, and then blend the component (A). In addition, if necessary, mixing may be conducted, while heating is conducted at a temperature in the range of 50 to 150°C. In addition, each component may be mixed at once, or may be mixed portionwise.

### [Thermal Conductivity]

The thermal conductivity of the thermally conductive composition of the present invention at 25°C is preferably 30.0 W/m·K or higher, more preferably 35.0 W/m·K or higher, and further preferably 40.0 W/m·K or higher. The use of a substance having a high thermal conductivity as each of the low-melting point metal and the filler, which are the base materials, enables the thermally conductive composition of the present invention to achieve a higher thermal conductivity.

The thermally conductive composition of the present invention can be used as a grease. The mode of use of the composition of the present invention as a grease is not particularly limited, and the composition may be used in the same method as that for a conventional heat dissipation (thermally conductive) silicone grease. For example, the composition of the present invention can be used preferably in a mode in which the grease is placed between an electrical·electronic component such as an LSI or a different heat-generating member and a cooling member or a heat dissipation member, and heat is dissipated by transferring heat from the heat-generating member to the cooling member or the heat dissipation member. The thermally conductive composition of the present invention has a high thermal conductivity, and is excellent in workability, and hence can be used as a heat dissipation (thermally conductive) grease for high-grade semiconductor devices and the like.

### EXAMPLES

Hereinafter, the present invention is described specifically by using Working Examples and Comparative Examples; however, the present invention is not limited thereto.

### Component (A)

(A-1) Gallium metal [melting point = 29.8°C]
(A-2) Ga-In alloy [mass ratio = 75.4:24.6, melting point = 15.7°C]
(A-3) Ga-In-Sn alloy [mass ratio = 68.5:21.5:13, melting point = -19°C]
(A-4) Ga-In-Sn alloy [mass ratio = 62:25:13, melting point = 5.0°C]
(A-5) Ga-In-Zn alloy [mass ratio = 82:12:6, melting point = 17°C]

### Component (B)

(B-1) Aluminum nitride powder [average particle diameter: 100 µm]
(B-2) Aluminum nitride powder [average particle diameter: 70 µm]
(B-3) Aluminum nitride powder [average particle diameter: 60 µm]
(B-4) Aluminum nitride powder [average particle diameter: 20 µm]
(B-5) Aluminum nitride powder [average particle diameter: 5 µm]
(B-6) Aluminum nitride powder [average particle diameter: 1 µm]
(B-7) Zinc oxide powder [average particle diameter: 1 µm]

### Grain Diameter Measurement

The grain diameter measurement of the thermally conductive fillers (component (B)) was conducted with a laser diffraction and scattering particle diameter distribution-measuring instrument (a particle size analyzer MICROTRAC MT3300EX manufactured by NIKKISO CO., LTD. in the present Working Examples). The grain diameter measured was a volume-based cumulative average diameter.

### Component (C): Hydrophobic Spherical Silica Fine Particles

As the component (C), hydrophobic spherical silica fine particles (C-1) to (C-6) were prepared as follows (Table 1). Note that, of these hydrophobic spherical silica fine particles, (C-5) and (C-6) were prepared for Comparative Examples.

### Component (D)

(D-1) Organosilane represented by structural formula: C₁₀H₂₁Si(OCH₃)₃
(D-2) Organosilane represented by structural formula: C₁₆H₃₃Si(OCH₃)₃
(D-3) Organosilane represented by structural formula: (ClCH₂CH₂CH₂)Si(OCH₃)₃

### [Synthesis of Hydrophobic Spherical Silica Fine Particles]

### Synthesis Example 1

### ·Step (C1): Synthesis Step of Hydrophilic Spherical Silica Fine Particles

In a 3-liter glass reaction vessel equipped with a stirrer, a dropping funnel, and a thermometer, 989.5 g of methanol, 135.5 g of water, and 66.5 g of 28% by mass ammonia water were placed and mixed together. The solution was adjusted to 35°C, and 436.5 g (2.87 mol) of tetramethoxysilane was added dropwise over 6 hours under stirring. After the dropwise addition was completed, stirring was continued for additional 0.5 hours to conduct hydrolysis. Thus, a suspension of hydrophilic spherical silica fine particles was obtained.

### Step (C2): Surface Treatment Step with Trifunctional Silane Compound

To the suspension obtained in step (C1), 4.4 g (0.03 mol) of methyltrimethoxysilane was added dropwise at room temperature over 0.5 hours, and, after the dropwise addition, stirring was continued for 12 hours to conduct a hydrophobization treatment on the surfaces of the silica fine particles. Thus, a dispersion of hydrophobic spherical silica fine particles was obtained.

### Concentration Step

Subsequently, an ester adaptor and a condenser were attached to the glass reaction vessel, and the dispersion obtained in step (C2) was heated to 60 to 70°C to remove by distillation 1,021 g of a mixture of methanol and water. Thus, a concentrated mixture solvent dispersion of hydrophobic spherical silica fine particles was obtained. Here, the amount of hydrophobic spherical silica fine particles contained in the concentrated dispersion was 28% by mass.

### Step (C3): Surface Treatment Step with Monofunctional Silane Compound

To the concentrated dispersion obtained in the concentration step, 138.4 g (0.86 mol) of hexamethyldisilazane was added at room temperature, and then the dispersion was heated to 50 to 60°C to allow the reaction to proceed for 9 hours. Thus, the silica fine particles in the dispersion were subjected to trimethylsilylation. Subsequently, the solvent in the dispersion was removed by distillation at 130°C under reduced pressure (6,650 Pa) to obtain 186 g of hydrophobic spherical silica fine particles (C-1).

The hydrophilic spherical silica fine particles obtained in step (C1) were measured according to a measurement method 1 described below. In addition, the hydrophobic spherical silica fine particles obtained through the above-described steps (C1) to (C3) were measured according to measurement methods 2 to 3 described below. Table 1 shows the obtained results.

### [Measurement Methods 1 to 3]

### 1. Particle Diameter Measurement of Hydrophilic Spherical Silica Fine Particles Obtained in Step (C1)

The suspension of silica fine particles was added to methanol at a final silica fine particle concentration of 0.5% by mass, and the fine particles were dispersed by ultrasonication for 10 minutes. The particle size distribution of the thus treated fine particles was measured with a dynamic light scattering/laser doppler NANOTRAC particle size distribution-measuring instrument (manufactured by NIKKISO CO., LTD. under the trade name: UPA-EX150), and the volume-based median diameter was employed as the particle diameter. Note that the median diameter is the particle diameter that corresponds to cumulative 50% in a case where the particle size distribution is expressed as a cumulative distribution.

### 2. Particle Diameter Measurement and Particle Size Distribution D₉₀/D₁₀ Measurement of Hydrophobic Spherical Silica Fine Particles Obtained in Step (C3)

The silica fine particles were added to methanol at a final concentration of 0.5% by mass, and the fine particles were dispersed by ultrasonication for 10 minutes. The particle size distribution of the thus treated fine particles was measured with a dynamic light scattering/laser doppler NANOTRAC particle size distribution-measuring instrument (manufactured by NIKKISO CO., LTD. under the trade name: UPA-EX150), and the volume-based median diameter was employed as the particle diameter. For the measurement of the particle size distribution D₉₀/D₁₀, the particle diameter at which cumulative 10% from the smaller side was reached in the distribution of the above-described particle diameter measurement was regarded as D₁₀, and the particle diameter at which cumulative 90% from the smaller side was reached was regarded as D₉₀, and the D₉₀/D₁₀ was calculated from the measured values.

### 3. Measurement of Shapes and Circularity of Hydrophobic Spherical Silica Fine Particles

Observation was conducted with an electron microscope (manufactured by Hitachi, Ltd. under the trade name: model S-4700, magnification: 100,000 times) to identify the shapes. "Spherical" encompasses not only perfect spheres but also somewhat distorted spheres.

Note that the shape of such a particle was evaluated based on the circularity of the two-dimensional projection of the particle. Here, the circularity is (the perimeter of a circle having the same area as that of the particle)/(the perimeter of the particle), and should be in the range of 0.8 to 1. Note that the circularity is the average value of the results of measurement of 10 particles.

### Synthesis Example 2

Hydrophobic spherical silica fine particles (C-2) (188 g) were obtained in the same manner as in Synthesis Example 1, except that the amounts of methanol, water, and 28% by mass ammonia water in step (C1) in Synthesis Example 1 was changed to 1,045.7 g of methanol, 112.6 g of water, and 33.2 g of 28% by mass ammonia water. Measurement was conducted by using the hydrophobic spherical silica fine particles (C-2) in the same manner as in the measurement in Synthesis Example 1. Table 1 shows the results.

### Synthesis Example 3

### ·Step (C1):

To a 3-liter glass reaction vessel equipped with a stirrer, a dropping funnel, and a thermometer, 623.7 g of methanol, 41.4 g of water, and 49.8 g of 28% by mass ammonia water were added, and mixed together. The solution was adjusted to 35°C, and addition of 1,163.7 g of tetramethoxysilane and addition of 418.1 g of 5.4% by mass ammonia water to the solution were simultaneously started under stirring. The former was added dropwise over 6 hours, and the latter was added dropwise over 4 hours. After the dropwise addition of tetramethoxysilane, the stirring was continued for 0.5 hours to conduct hydrolysis. Thus, a suspension of silica fine particles was obtained.

### Step (C2):

To the thus obtained suspension, 11.6 g (0.01 equivalents relative to tetramethoxysilane in terms of mole ratio) of methyltrimethoxysilane was added dropwise at room temperature over 0.5 hours, and after the dropwise addition, stirring was conducted for 12 hours, to treat the surfaces of the silica fine particles.

To the glass reaction vessel, an ester adaptor and a condenser were attached. To the dispersion containing the silica fine particles subjected to the above-described surface treatment, 1,440 g of methyl isobutyl ketone was added followed by heating at 80 to 110°C, to remove methanol and water by distillation over 7 hours.

### Step (C3):

To the thus obtained dispersion, 357.6 g of hexamethyldisilazane was added at room temperature followed by heating to 120°C to allow the reaction to proceed for 3 hours. Thus, the silica fine particles were subjected to trimethylsilylation. After that, the solvent was removed by distillation under reduced pressure, to obtain 472 g of hydrophobic spherical silica fine particles (C-3).

The thus obtained hydrophobic spherical silica fine particles (C-3) were subjected to measurement in the same manner as in Synthesis Example 1. Table 1 shows the results.

### Synthesis Example 4

All the steps were conducted in the same manner as in Synthesis Example 3, except that the temperature at which tetramethoxysilane was hydrolyzed was changed from 35°C to 20°C for the synthesis of silica fine particles, to obtain 469 g of hydrophobic spherical silica fine particles (C-4). Measurement was conducted by using the hydrophobic spherical silica fine particles (C-4) in the same manner as in Synthesis Example 1. Table 1 shows the results.

### Comparative Synthesis Example 1

In a 0.3-liter glass reaction vessel equipped with a stirrer and a thermometer, 100 g of silica (trade name: SOC1, manufactured by ADMATECHS COMPANY LIMITED) produced by the vaporized metal combustion method was placed, and 1 g of pure water was added under stirring. After the reaction vessel was hermetically sealed, the mixture was stirred further at 60°C for 10 hours. Subsequently, the mixture was cooled to room temperature, and then 2 g of hexamethyldisilazane was added under stirring. After the reaction vessel was hermetically sealed, the mixture was further stirred for 24 hours. The temperature was raised to 120°C, and the remaining raw material and the produced ammonia were removed under a nitrogen gas flow, to obtain 100 g of hydrophobic spherical silica fine particles (C-5).

The obtained hydrophobic spherical silica fine particles (C-5) were measured in the same manner as in Synthesis Example 1. Table 1 shows the results.

### Comparative Synthesis Example 2

In a 0.3-liter glass reaction vessel equipped with a stirrer and a thermometer, 100 g of silica (trade name: SOC1, manufactured by ADMATECHS COMPANY LIMITED) produced by the vaporized metal combustion method was placed, and 1 g of pure water was added under stirring. After the reaction vessel was hermetically sealed, the mixture was stirred further at 60°C for 10 hours. Subsequently, the mixture was cooled to room temperature, and then 1 g of methyltrimethoxysilane was added under stirring. After the reaction vessel was hermetically sealed, the mixture was further stirred for 24 hours. Next, 2 g of hexamethyldisilazane was added under stirring. After the reaction vessel was hermetically sealed, the mixture was further stirred for 24 hours. The temperature was raised to 120°C, and the remaining raw material and the produced ammonia were removed under a nitrogen gas flow, to obtain 101 g of hydrophobic spherical silica fine particles (C-6). The obtained hydrophobic spherical silica fine particles (C-6) were measured in the same manner as in Synthesis Example 1. Table 1 shows the results.

**[Table 1]**

| | Synthesis Example 1 | Synthesis Example 2 | Synthesis Example 3 | Synthesis Example 4 | Comparative Synthesis Example 1 | Comparative Synthesis Example 2 |
|---|---|---|---|---|---|---|
| Hydrophobic Spherical Silica Fine Particles | (C-1) | (C-2) | (C-3) | (C-4) | (C-5) | (C-6) |
| Particle Diameter ¹⁾ (nm) | 52 | 11 | 115 | 230 | - | - |
| Particle Diameter ²⁾ (nm) | 52 | 11 | 115 | 238 | 300 | 300 |
| Particle Size Distribution D₉₀/D₁₀ | 2.21 | 2.40 | 2.23 | 2.80 | 5.40 | 4.80 |
| Shape ²⁾ | Spherical | Spherical | Spherical | Spherical | Spherical | Nonuniform Shapes |
| Circularity | 0.86 | 0.92 | 0.90 | 0.81 | 0.80 | 0.65 |

### <Note>

1) The particle diameter of hydrophilic spherical silica fine particles in the dispersion obtained in step (C1)
2) The particle diameter of the finally obtained hydrophobic spherical silica fine particles

### [Working Examples 1 to 31 and Comparative examples 1 to 2]

### <Preparation of Compositions>

Each composition was prepared by taking the components at the corresponding compositional ratio described in Tables 2 to 6, and placing the components in a planetary mixer with a capacity of 1 liter (for example, trade name: HIVIS MIX model 2P-1 manufactured by PRIMIX Corporation), followed by stirring at room temperature for 1 hour.

Note that the component (A-1), which has a melting point higher than room temperature, was introduced, after melted in an oven in advance.

### <Appearance>

The state of each of the obtained compositions was visually observed. Tables 2 to 6 show the results.

### <Measurement of Thermal Conductivity>

The thermal conductivity of each composition was measured at 25°C with a thermophysical property-measuring instrument (in the present Working Examples, TPS-2500S manufactured by KYOTO ELECTRONICS MANUFACTURING CO., LTD.) using the hot disk method.

### <Evaluation of Workability>

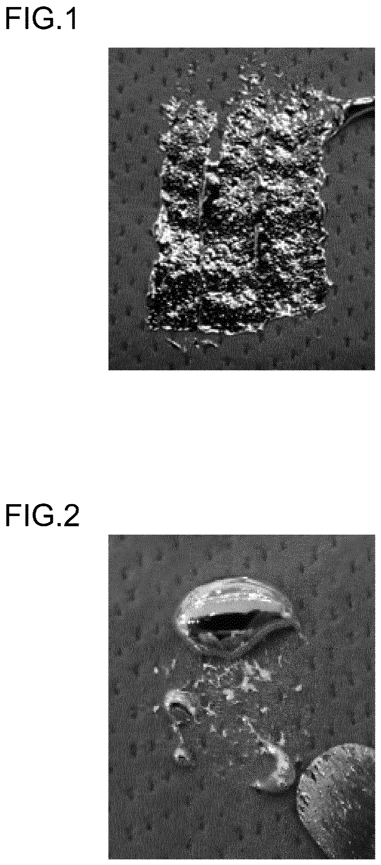

Each composition (about 1.5 mL) was loaded in a disposable syringe (for example, Terumo Syringe SS-02SZ, 2.5 mL, central entrance, needle-free), and then the plunger was pushed to discharge the composition. The discharged composition was spread by pushing with a spatula or the like. Here, compositions that spread by wetting were marked with "o" (after being crushed, the compositions did not easily return to a droplet state), and evaluated as having good workability (Fig. 1). Compositions that did not sufficiently spread by wetting were marked with "×" (after being crushed, the compositions easily reverted to a droplet state), and evaluated as having poor workability (Fig. 2).

**[Table 2]**

| | Working Example 1 | Working Example 2 | Working Example 3 | Working Example 4 | Working Example 5 | Working Example 6 | Working Example 7 | Working Example 8 | Working Example 9 | Working Example 10 |
|---|---|---|---|---|---|---|---|---|---|---|
| (A-1) | 100 | 100 | 100 | 100 | | | | 100 | 100 | 100 |
| (A-2) | | | | | 100 | | | | | |
| (A-3) | | | | | | 100 | | | | |
| (A-4) | | | | | | | | | | |
| (A-5) | | | | | | | 100 | | | |
| (B-1) | 18.5 | 16.4 | 18.5 | | | | | | | |
| (B-2) | | | | | 40 | 40 | 40 | | | |
| (B-3) | | | | | | | | 40 | | |
| (B-4) | 12.8 | 6.8 | 6.16 | 15.9 | | | | | | |
| (B-5) | 6.1 | 3.3 | | 5.3 | | | | | 20 | |
| (B-6) | | 6.8 | | | | | | | | 3.5 |
| (B-7) | | | 8.5 | 11.2 | | | | | | 1.5 |
| | | | | | | | | | | |
| Appearance | Paste | Paste | Paste | Paste | Paste | Paste | Paste | Paste | Paste | Paste |
| Thermal Conductivity W/m·K | 63.6 | 30 | 35 | 36 | 43 | 43 | 43 | 38 | 30 | 30 |
| Workability | ○ | ○ | ○ | ○ | ○ | ○ | ○ | ○ | ○ | ○ |

**[Table 3]**

| | Working Example 11 | Working Example 12 | Working Example 13 | Working Example 14 | Working Example 15 | Working Example 16 | Working Example 17 | Working Example 18 | Working Example 19 | Working Example 20 |
|---|---|---|---|---|---|---|---|---|---|---|
| (A-4) | 100 | 100 | 100 | 100 | 100 | 100 | 100 | 100 | 100 | 100 |
| (B-1) | | | | 16.8 | 16.8 | 16.8 | 16.8 | | 18.5 | 18.5 |
| (B-2) | 17.5 | | 15.9 | | | | | 18.4 | | |
| (B-3) | | 29.8 | | | | | | | | |
| (B-4) | 17.5 | 6.8 | 15.9 | 15.8 | 15.8 | 15.8 | 15.8 | 16.6 | 12.8 | 12.8 |
| (B-5) | 17.5 | 6.8 | 15.9 | 7.9 | 7.9 | 7.9 | 7.9 | 5.6 | 6.1 | 6.1 |
| (B-6) | | 13 | | | | | | | | |
| (B-7) | 1.6 | | 1.5 | | | | | | | |
| (C-1) | | | | 0.6 | | | | | | |
| (C-2) | | | | | 0.6 | | | | | |
| (C-3) | 0.11 | 0.1 | 0.1 | | | 0.6 | | | | |
| (C-4) | | | | | | | 0.6 | | | |
| (D-1) | | | | | | | | | | 0.2 |
| | | | | | | | | | | |
| Appearance | Paste | Paste | Paste | Paste | Paste | Paste | Paste | Paste | Paste | Paste |
| Thermal Conductivity W/m·K | 67.2 | 56 | 57 | 48.3 | 48.3 | 48.3 | 48.3 | 54.2 | 62.9 | 55 |
| Workability | ○ | ○ | ○ | ○ | ○ | ○ | ○ | ○ | ○ | ○ |

**[Table 4]**

| | Working Example 21 | Working Example 22 | Working Example 23 | Working Example 24 | Working Example 25 | Working Example 26 | Working Example 27 | Working Example 28 | Working Example 29 |
|---|---|---|---|---|---|---|---|---|---|
| (A-2) | | | | 100 | | | | | |
| (A-3) | | | | | | 100 | | | |
| (A-4) | 100 | | 100 | | 100 | | 100 | 100 | 100 |
| (A-5) | | 100 | | | | | | | |
| (B-1) | | | 38.5 | 38.5 | 45.2 | 45.2 | 43.9 | 39.8 | 42.2 |
| (B-2) | 32.5 | 32.5 | | | | | | | |
| (B-3) | | | 9.6 | 9.6 | 7.2 | 7.2 | 8.8 | 10.7 | 10.2 |
| (B-4) | 8.1 | 8.1 | 4.8 | 4.8 | | | 3.9 | 4.7 | 4.2 |
| (B-5) | 13.0 | 13.0 | | | | | | | |
| (B-6) | | | 4.8 | 4.8 | | | | 2.3 | |
| (B-7) | 1.1 | 1.1 | | | 0.8 | 0.8 | 1.3 | | 1.3 |
| (C-3) | 0.1 | 0.1 | | | | | | | |
| Appearance | Paste | Paste | Paste | Paste | Paste | Paste | Paste | Paste | Paste |
| Thermal Conductivity W/m·K | 72.5 | 74.5 | 81.7 | 85.6 | 89.4 | 89.3 | 89.5 | 91.7 | 94 |
| Workability | ○ | ○ | ○ | ○ | ○ | ○ | ○ | ○ | ○ |

**[Table 5]**

| | Working Example 30 | Working Example 31 |
|---|---|---|
| (A-4) | 100 | 100 |
| (B-1) | 18.5 | 18.5 |
| (B-2) | | |
| (B-3) | | |
| (B-4) | 12.8 | 12.8 |
| (B-5) | 6.1 | 6.1 |
| (B-6) | | |
| (B-7) | | |
| (D-1) | | |
| (D-2) | 0.3 | |
| (D-3) | | 0.3 |
| Appearance | Paste | Paste |
| Thermal Conductivity W/m·K | 55 | 56 |
| Workability | ○ | ○ |

**[Table 6]**

| | Comparative Example 1 | Comparative Example 2 |
|---|---|---|
| (A-1) | 100 | 100 |
| (A-4) | | |
| (B-1) | | |
| (B-4) | 1 | 106 |
| (B-5) | | |
| (B-7) | 0.4 | 46 |
| | | |
| Appearance | Liquid | Powder |
| Thermal Conductivity W/m·K | 24 | Not Measurable |
| Workability | × | × |

From Working Examples, it was found that the thermally conductive compositions of the present invention were excellent in workability and had high thermal conductivity. In particular, it was found from Working Examples 21 to 29 that the thermal conductivity was improved, when a metal oxide and/or metal nitride having an average particle diameter of 70 to 200 µm was blended as the component (B) at a high ratio that was 55% by mass or higher and lower than 100% by mass with respect to the entire component (B).

From Working Examples 21 to 29, it has been found that a preferred formulation having high thermal conductivity and being excellent in workability is a composition containing:
a component (B) that has an average particle diameter of 70 to 200 µm and that accounts for 55% by mass or more of the components (B);
a component (B) that has an average particle diameter of 20 µm or larger and smaller than 70 µm and that accounts for 10 to 35% by mass of the components (B); and
a component (B) that has an average particle diameter smaller than 20 µm and that accounts for 30% by mass or less of the components (B),
a more preferred formulation is a composition containing:
   a component (B) that has an average particle diameter of 70 to 200 µm and that accounts for 57% by mass or more of the components (B);
   a component (B) that has an average particle diameter of 20 µm or larger and smaller than 70 µm and that accounts for 12 to 30% by mass; and
a component (B) that has an average particle diameter smaller than 20 µm and that accounts for 28% by mass or less, and
an exemplary further preferred formulation is a composition containing:
   a component (B) that has an average particle diameter of 70 to 200 µm and that accounts for 59% by mass or more of the components (B);
   a component (B) that has an average particle diameter of 20 µm or larger and smaller than 70 µm and that accounts for 14 to 28% by mass; and
   a component (B) that has an average particle diameter smaller than 20 µm and that accounts for 26% by mass or less.

## Claims

1. A thermally conductive composition, comprising:
(A) 100 parts by mass of gallium and/or an alloy thereof having a melting point of -20 to 100°C; and
(B) 2 to 150 parts by mass of a metal oxide and/or metal nitride, having an average particle diameter of 0.01 µm to 200 µm, with respect to 100 parts by mass of the component (A),
wherein the total content of the components (A) and (B) in the composition is 95 to 100% by mass.

2. The thermally conductive composition according to claim 1, wherein the total content of the components (A) and (B) in the composition is 98 to 100% by mass.

3. The thermally conductive composition according to claim 1, wherein the gallium alloy serving as the component (A) comprises one or more selected from Ga-In alloys, Ga-Sn-Zn alloys, Ga-In-Sn alloys, and Ga-In-Bi-Sn alloys.

4. The thermally conductive composition according to claim 1, wherein the component (B) comprises one or more selected from zinc oxide powder, alumina powder, boron nitride powder, silicon nitride powder, aluminum nitride powder, aluminum hydroxide powder, and magnesium oxide powder.

5. The thermally conductive composition according to claim 1, further comprising, as a component (C), 0.01 to 10 parts by mass, with respect to 100 parts by mass of the component (A), of hydrophobic spherical silica fine particles as defined in the following,
wherein the hydrophobic spherical silica fine particles are those in which R¹SiO_{3/2} units and R²₃SiO_{1/2} units are introduced onto surfaces of hydrophilic spherical silica fine particles that have been obtained by hydrolyzing and condensing a tetrafunctional silane compound, a partially hydrolyzed and condensed product thereof, or a mixture thereof and that are substantially composed of SiO₂ units,
wherein R¹ is a substituted or unsubstituted monovalent hydrocarbon group having 1 to 20 carbon atoms, and
wherein R²s are substituted or unsubstituted monovalent hydrocarbon groups having 1 to 8 carbon atoms and are same or different from each other, and
wherein the hydrophobic spherical silica fine particles have particle diameters in a range of 0.005 to 1 µm, a particle size distribution D₉₀/D₁₀ value of 3 or lower, and an average circularity of 0.8 to 1.

6. The thermally conductive composition according to claim 1, further comprising, as a component (D), 0.001 to 10 parts by mass of an organosilane represented by the following general formula (1) with respect to 100 parts by mass of the component (A):
R¹ₐR²_{b}Si(OR³)_{4-a-b} (1),
wherein R¹s are each independently a substituted or unsubstituted alkyl group having 1 to 20 carbon atoms, R²s are each independently a substituted or unsubstituted monovalent hydrocarbon group other than alkyl groups, R³s are the same or different monovalent hydrocarbon groups having 1 to 6 carbon atoms, a is a number of 1 to 3, b is a number of 0 to 2, and the sum of a + b is a number of 1 to 3.
